# EUROPEAN PATENT APPLICATION

(11) **EP 4 539 627 A1**
(43) Date of publication of application: **16.04.2025**
(21) Application number: 24177617.8
(22) Date of filing: 23.05.2024
(51) Int. Cl.: H10B 41/27, H01L 25/065, H10B 41/50, H10B 43/27, H10B 43/50

(54) **THREE-DIMENSIONAL SEMICONDUCTOR MEMORY DEVICE AND ELECTRONIC SYSTEM INCLUDING THE SAME**

(30) Priority: 11.10.2023 KR 20230134903
(71) Applicant: Samsung Electronics Co., Ltd., Suwon-si, Gyeonggi-do 16677 (KR)
(72) Inventor: SHIN, Minsoo, 16677 Suwon-si, Gyeonggi-do (KR); SHIN, Joongshik, 16677 Suwon-si, Gyeonggi-do (KR); KIM, Hyeongjin, 16677 Suwon-si, Gyeonggi-do (KR); HAN, Jeehoon, 16677 Suwon-si, Gyeonggi-do (KR)
(74) Representative: Kuhnen & Wacker Patent- und Rechtsanwaltsbüro PartG mbB

(57) **Abstract**

A three-dimensional semiconductor memory device includes peripheral circuit structures (PS) on a substrate (10), stacked structures (ST) configured to each include gate electrodes (GE1, GE2) stacked on the peripheral circuit structures in a first direction (D1) perpendicular to a lower surface of the substrate, and to be spaced apart from each other in a second direction (D2) parallel to the lower surface of the substrate, a separation structure (SS) configured to extend between the stacked structures in a third direction (D3) intersecting the first direction and the second direction, and to include support patterns (SU) arranged to be spaced apart from each other in the third direction in the separation structure, and an internal insulating layer (ID) surrounding a side surface of each of the support patterns.

## Description

### CROSS-REFERENCE TO RELATED APPLICATIONS

This application claims priority to Korean Patent Application No.10-2023-0134903, filed in the Korean Intellectual Property Office on October 11, 2023, , the disclosure of which is incorporated by reference herein in its entirety.

### BACKGROUND

A need may arise to have a semiconductor device capable of storing a large amount of data in an electronic system which may need data storage. Semiconductor devices have been highly integrated to meet high performance and low manufacturing cost, which are desired by customers. Integration of typical two-dimensional or planar semiconductor devices is primarily determined by the area occupied by a unit memory cell, such that it is greatly influenced by the level of technology for forming fine patterns. However, the expensive processing equipment needed to increase pattern fineness may set a practical limitation on increasing the integration of the two-dimensional or planar semiconductor devices. Accordingly, there have been proposed three-dimensional semiconductor memory devices having three-dimensionally arranged memory cells.

### SUMMARY

In general, in some aspects, the present disclosure is directed toward a three-dimensional semiconductor memory device having improved productivity and an electronic system including the same.

In general, according to some aspects, the present disclosure is directed to a three-dimensional semiconductor memory device having peripheral circuit structures on a substrate, stacked structures configured to each include gate electrodes stacked on the peripheral circuit structures in a first direction perpendicular to a lower surface of the substrate, and to be spaced apart from each other in a second direction parallel to the lower surface of the substrate, a separation structure configured to extend between the stacked structures in a third direction intersecting the first direction and the second direction, and to include support patterns arranged to be spaced apart from each other in the third direction in the separation structure, and an internal insulating layer surrounding a side surface of each of the support patterns.

According to some aspects of the present disclosure, a three-dimensional semiconductor memory device may include peripheral circuit structures on a substrate, stacked structures configured to each include gate electrodes stacked on the peripheral circuit structures in a first direction perpendicular to a lower surface of the substrate, and to be spaced apart from each other in a second direction parallel to the bottom surface of the substrate, and a separation structure to extend between the stacked structures in a third direction intersecting the first direction and the second direction, wherein the separation structure includes support patterns arranged to be spaced apart from each other in the third direction in the separation structure, and the support patterns are spaced apart from the gate electrodes.

According to some aspects of the present disclosure, an electronic system may include three-dimensional semiconductor memory device and a controller electrically connected to the three-dimensional semiconductor memory device through an input/output pad and controlling the three-dimensional semiconductor memory device, wherein the three-dimensional semiconductor memory device includes peripheral circuit structures on a substrate, stacked structures configured to each include gate electrodes stacked on the peripheral circuit structures in a first direction perpendicular to a lower surface of the substrate, and to be spaced apart from each other in a second direction parallel to the lower surface of the substrate, a separation structure configured to extend between the stacked structures in a third direction intersecting the first direction and the second direction, and to include support patterns arranged to be spaced apart from each other in the third direction in the separation structure, and an internal insulating layer surrounding a side surface of each of the support patterns.

### BRIEF DESCRIPTION OF THE DRAWINGS

FIG. 1 is a diagram schematically illustrating an example of an electronic system including a three-dimensional semiconductor memory device according to some implementations.
FIG. 2 is a perspective view schematically illustrating an example of an electronic system including a three-dimensional semiconductor memory device according to some implementations.
FIG. 3 is a cross-sectional view taken along line I-I' of FIG. 2 illustrating an example of a semiconductor package including a semiconductor device according to some implementation.
FIG. 4 is a cross-sectional view taken along line I-I' of FIG. 2 illustrating an example of a semiconductor package including a semiconductor device according to some implementations .
FIG. 5 is a plan view illustrating an example of a three-dimensional semiconductor memory device according to some implementations.
FIGS. 6A and 6B are cross-sectional views corresponding to lines A-A' and B-B' of FIG. 5, respectively, according to some implementations.
FIGS. 7A and 7B are enlarged views corresponding to portion 'P1' in FIG. 6A, respectively, according to some implementations.
FIGS. 8A to 8C are plan views schematically illustrating examples of a three-dimensional semiconductor memory devices according to some implementations.
FIGS. 9 to 17B are cross-sectional views illustrating an example of a method of manufacturing a three-dimensional semiconductor memory device according to some implementations.

### DETAILED DESCRIPTION

Hereinafter, example implementations will be explained in detail with reference to the accompanying drawings.

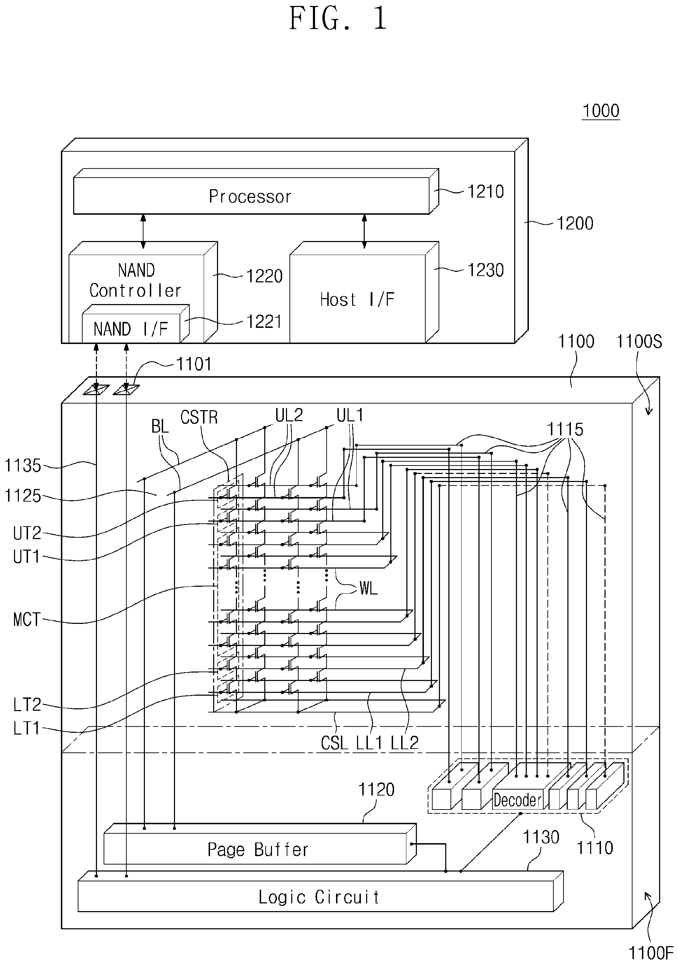

FIG. 1 is a diagram schematically illustrating an example of an electronic system including a three-dimensional semiconductor memory device according to some implementations. In FIG. 1, an electronic system 1000 may include a three-dimensional semiconductor memory device 1100 and a controller 1200 electrically connected to the three-dimensional semiconductor memory device 1100. The electronic system 1000 may be a storage device that includes a single or a plurality of three-dimensional semiconductor memory devices 1100 or may be an electronic device that includes the storage device. For example, the electronic system 1000 may be a solid state drive (SSD) device, a computing system, a medical apparatus, or a communication apparatus, each of which includes a single or a plurality of three-dimensional semiconductor memory devices 1100.

The three-dimensional semiconductor memory device 1100 may be a non-volatile memory device, such as a three-dimensional NAND Flash memory device which will be discussed below. The three-dimensional semiconductor memory device 1100 may include a first region 1100F and a second region 1100S on the first region 1100F. However, different from that shown, the first region 1100F may be disposed on a side of the second region 1100S. The first region 1100F may be a peripheral circuit region that includes a decoder circuit 1110, a page buffer 1120, and a logic circuit 1130. As an example, The second region 1100S may be a memory cell region that includes bit lines BL, a common source line CSL, word lines WL, first lines LL1 and LL2, second lines UL1 and UL2, and memory cell strings CSTR between the bit line BL and the common source line CSL. As another example, the memory cell strings CSH may be disposed between the common source line CSL and the first region 1100F.

In the second region 1100S, each of the memory cell strings CSTR may include first transistors LT1 and LT2 adjacent to the common source line CSL, second transistors UT1 and UT2 adjacent to the bit line BL, and a plurality of memory cell transistors MCT disposed between the first transistors LT1 and LT2 and the second transistors UT1 and UT2. The number of the first transistors LT1 and LT2 and of the second transistors UT1 and UT2 may be variously changed in accordance with embodiments.

For example, the second transistors UT1 and UT2 may include a string selection transistor, and the first transistors LT1 and LT2 may include a ground selection transistor. The first lines LL1 and LL2 may be gate electrodes of the first transistors LT1 and LT2, respectively. The word lines WL may be gate electrodes of the memory cell transistors MCT, and the second lines UL1 and UL2 may be gate electrodes of the second transistors UT1 and UT2, respectively.

For example, the first transistors LT1 and LT2 may include a first erase control transistor and a ground selection transistor connected in series. For example, the second transistors UT1 and UT2 may include a string select transistor and a second erase control transistor connected in series.

The common source line CSL, the first lines LL1 and LL2, the word lines WL, and the second lines UL1 and UL2 may be electrically connected to the decoder circuit 1110 through first connection lines 1115 that extend from the first region 1100F toward the second region 1100S. The bit lines BL may be electrically connected to the page buffer 1120 through second connection lines 1125 that extend from the first region 1100F toward the second region 1100S.

In the first region 1100F, the decoder circuit 1110 and the page buffer 1120 may perform a control operation to at least one selection memory cell transistor among the plurality of memory cell transistors MCT. The logic circuit 1130 may control the decoder circuit 1110 and the page buffer 1120. The three-dimensional semiconductor memory device 1100 may communicate with the controller 1200 through an input/output pad 1101 electrically connected to the logic circuit 1130. The input/output pad 1101 may be electrically connected to the logic circuit 1130 through an input/output connection line 1135 that extends from the first region 1100F toward the second region 1100S.

The controller 1200 may include a processor 1210, a NAND controller 1220, and a host interface 1230. According to some implementations, the electronic system 1000 may include a plurality of three-dimensional semiconductor memory devices 1100, and in this case, the controller 1200 may control the plurality of three-dimensional semiconductor memory devices 1100.

The processor 1210 may control overall operations of the electronic system 1000 including the controller 1200. The processor 1210 may operate based on predetermined firmware, and may control the NAND controller 1220 to access the three-dimensional semiconductor memory device 1100. The NAND controller 1220 may include a NAND interface 1221 that processes communication with the three-dimensional semiconductor memory device 1100. The NAND interface 1221 may be used to transfer therethrough a control command to control the three-dimensional semiconductor memory device 1100, data which is intended to be written on the memory cell transistors MCT of the three-dimensional semiconductor memory device 1100, and/or data which is intended to be read from the memory cell transistors MCT of the three-dimensional semiconductor memory device 1100. The host interface 1230 may provide the electronic system 1000 with communication with an external host. When a control command is received through the host interface 1230 from an external host, the three-dimensional semiconductor memory device 1100 may be controlled by the processor 1210 in response to the control command.

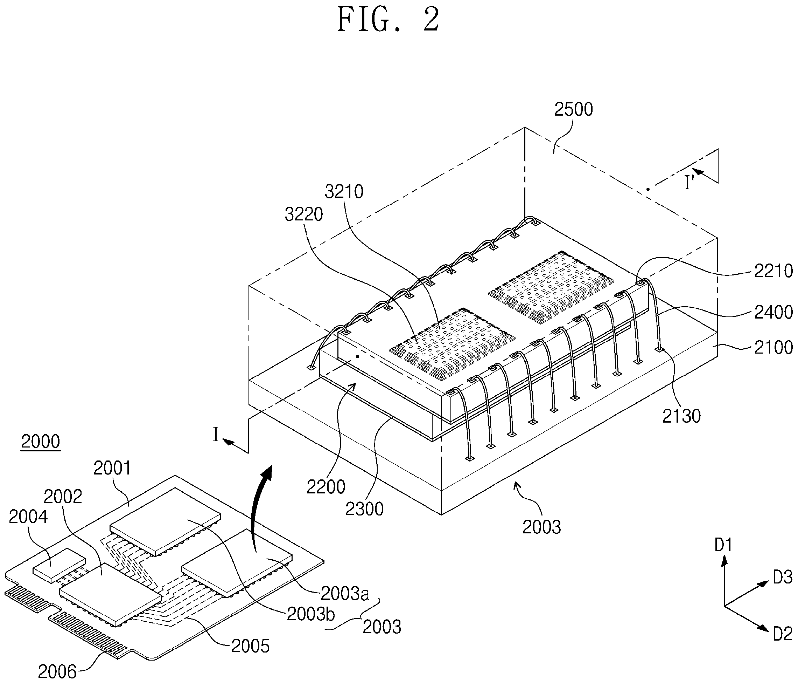

FIG. 2 is a perspective view schematically illustrating an example of an electronic system including a three-dimensional semiconductor memory device according to some implementations. In FIG. 2, an electronic system 2000 according to some embodiments of the present inventive concepts may include a main board 2001, a controller 2002 mounted on the main board 2001, one or more semiconductor packages 2003, and a dynamic random access memory (DRAM) 2004. The semiconductor package 2003and the DRAM 2004 may be connected to the controller 2002 through wiring patterns 2005 provided in the main board 2001.

The main board 2001 may include a connector 2006 including a plurality of pins which are provided to have connection with an external host. The number and arrangement of the plurality of pins on the connector 2006 may be changed based on a communication interface between the electronic system 2000 and the external host. The electronic system 2000 may communicate with the external host through one or more interfaces, for example, universal serial bus (USB), peripheral component interconnect express (PIC-Express), serial advanced technology attachment (SATA), and/or M-PHY for universal flash storage (UFS). For example, the electronic system 2000 may operate with power supplied through the connector 2006 from the external host. The electronic system 2000 may further include a power management integrated circuit (PMIC) that distributes the power supplied from the external host to the controller 2002 and the semiconductor package 2003.

The controller 2002 may write data to the semiconductor package 2003, may read data from the semiconductor package 2003, or may increase an operating speed of the electronic system 2000.

The DRAM 2004 may be a buffer memory that reduces a difference in speed between the external host and the semiconductor package 2003 that serves as a data storage space. The DRAM 2004 included in the electronic system 2000 may operate as a cache memory, and may provide a space for temporary data storage in a control operation of the semiconductor package 2003. When the DRAM 2004 is included in the electronic system 2000, the controller 2002 may include not only a NAND controller for control of the semiconductor package 2003, but a DRAM controller for control of the DRAM 2004.

The semiconductor package 2003 may include a first semiconductor package 2003 a and a second semiconductor package 2003b that are spaced apart from each other. Each of the first and second semiconductor packages 2003a and 2003b may include a plurality of semiconductor chips 2200. Each of the first and second semiconductor packages 2003a and 2003b may include a package substrate 2100, semiconductor chips 2200 on the package substrate 2100, adhesive layers 2300 on bottom surfaces of the semiconductor chips 2200, connection structures 2400 that electrically connect the semiconductor chips 2200 to the package substrate 2100, and a molding layer 2500 that lies on the package substrate 2100 and covers or overlaps the semiconductor chips 2200 and the connection structures 2400.

The package substrate 2100 may be an integrated circuit board including package upper pads 2130. For example, each semiconductor chip 2200 may include input/output pads 2210. Each of the input/output pads 2210 may correspond to the input/output pad 1101 of FIG. 1. Each of the semiconductor chips 2200 may include gate stacked structures 3210 and memory channel structures 3220. Each of the semiconductor chips 2200 may include a three-dimensional semiconductor memory device as will be described later.

The connection structures 2400 may be, for example, bonding wires that electrically connect the input/output pads 2210 to the package upper pads 2130. Accordingly, in each of the first and second semiconductor packages 2003a and 2003b, the semiconductor chips 2200 may be electrically connected to each other in a wire bonding manner, and may be electrically connected to the package upper pads 2130 of the package substrate 2100. In an example, in each of the first and second semiconductor packages 2003 a and 2003b, the semiconductor chips 2200 may be electrically connected to each other using through-silicon vias instead of the connection structures 2400 or the bonding wires.

Differently from FIG. 2, for example, the controller 2002 and the semiconductor chips 2200 may be included in a single package. The controller 2002 and the semiconductor chips 2200 may be mounted on a separate interposer substrate other than the main board 2001, and may be connected to each other through wiring lines provided in the interposer substrate.

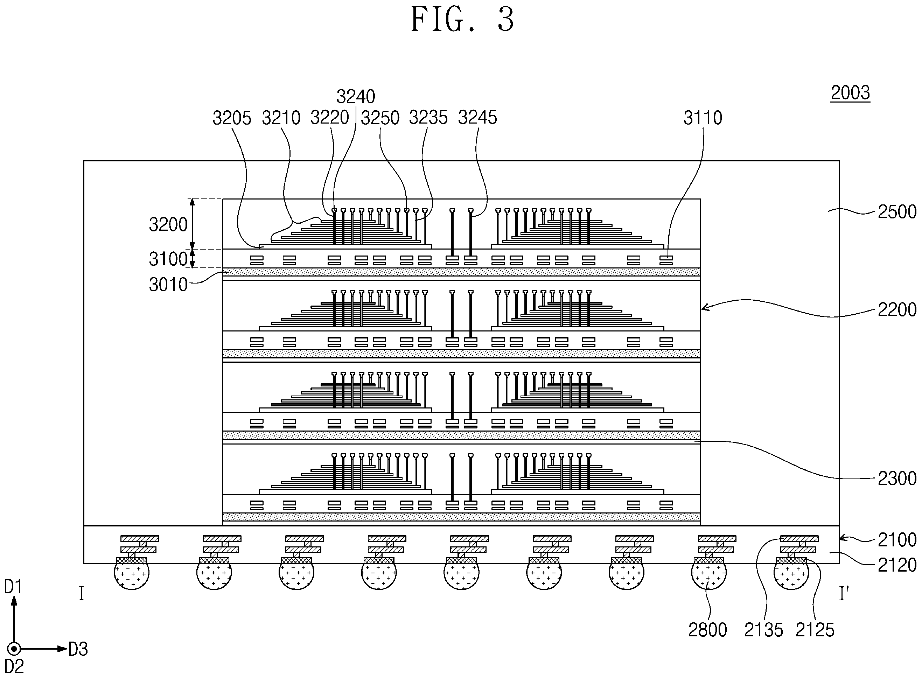

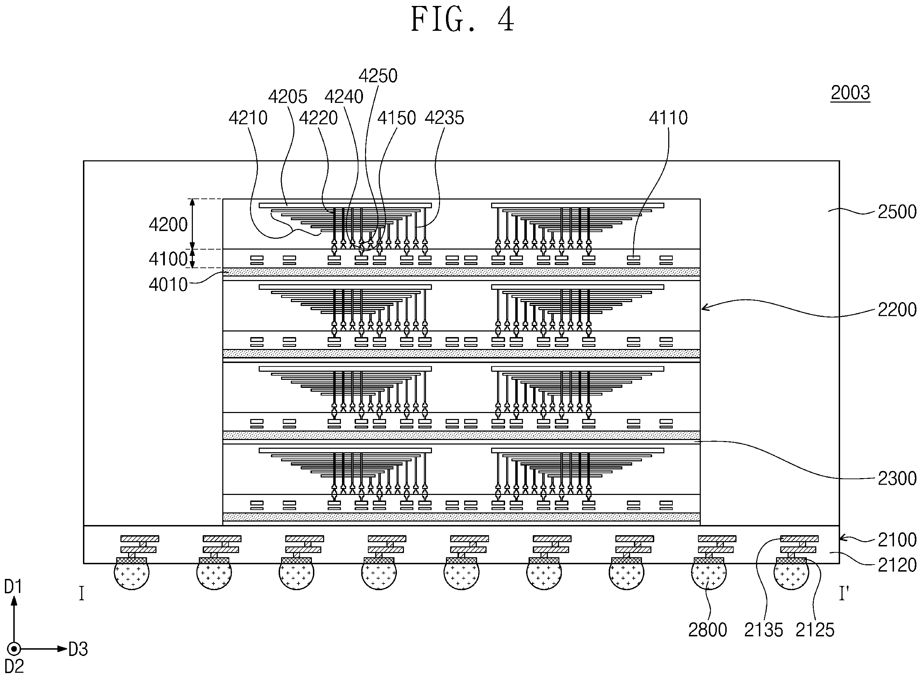

FIGS. 3 and 4 are cross-sectional views taken along line I-I' of FIG. 2 illustrating an example of a semiconductor package including a semiconductor device according to some implementations. In FIGS. 3 and 4, a semiconductor package 2003 may include a package substrate 2100, a plurality of semiconductor chips 2200 on the package substrate 2100, and a molding layer 2500 covering the package substrate 2100 and the semiconductor chips 2200.

The package substrate 2100 may include a package substrate body 2120, upper pads 2103 (in FIG. 2) disposed on or exposed through an upper surface of the package substrate body 2120, lower pads 2125 disposed on a lower surface of the package substrate body 2120 or exposed through the lower surface, and internal wirings 2135 electrically connecting the upper pads 2103 and the lower pads 2125 in the package substrate body 2120. The upper pads 2103 may be electrically connected to the connection structures 2400 (in FIG. 2). The lower pads 2125 may be connected to the wiring patterns 2005 of the main board 2001 of the electronic system 2000 shown in FIG. 2 through conductive connectors 2800.

As an example, sidewalls of the semiconductor chips 2200 may be aligned with each other, but the inventive concept is not limited thereto. As another example, the sidewalls of the semiconductor chips 2200 may not be aligned with each other. As an example, the semiconductor chips 2200 may be electrically connected to each other by the connection structures 2400 shown in FIG. 2 in the form of bonding wires. As another example, the semiconductor chips 2200 may be electrically connected to each other through a connection structure including a through electrode (TSV). Each of the semiconductor chips 2200 may include substantially the same components.

In FIG. 3, each of the semiconductor chips 2200 may include a semiconductor substrate 3010, a first structure 3100 on the semiconductor substrate 3010, and a second structure 3200 on the first structure 3100. The first structure 3100 may correspond to the first region 1100F (in FIG. 1), and the second structure 3200 may correspond to the second region 1100S (in FIG. 1). The first structure 3100 may include a peripheral circuit region including peripheral circuit wirings 3110. The second structure 3200 may include a common source line 3205, a gate stacked structure 3210 on the common source line 3205, memory channel structures 3220 penetrating the gate stacked structure 3210, bit lines 3240 electrically connected to the memory channel structures 3220, and gate contact plugs 3235 electrically connected to word lines (WL in FIG. 1) of the gate stacked structure 3210.

Each of the semiconductor chips 2200 may include a through wiring 3245 that is electrically connected to the peripheral wirings 3110 of the first structure 3100 and extends into the second structure 3200. The first structure 3100 may be electrically connected to the second structure 3200 through the through wiring 3245. As an example, the through wiring 3245 may penetrate the gate stacked structure 3210. Each of the semiconductor chips 2200 may further include an input/output pad 2210 shown in FIG. 2.

In FIG. 4, each of the semiconductor chips 2200 may include a semiconductor substrate 4010, a first structure 4100 on the semiconductor substrate 4010, and a second structure 4200 on the first structure 4100. The second structure 4200 may be coupled to the first structure 4100 using a wafer bonding manner.

The first structure 4100 may include peripheral circuit wirings 4110 and first bonding pads 4150. The second structure 4200 may include a common source line 4205, a gate stacked structure 4210 between the common source line 4205 and the first structure 4100, memory channel structures 4220 penetrating the gate stacked structure 4210, and second bonding pads 4250 electrically connected to the memory channel structures 4220 and the word lines (WL in FIG. 1) of the gate stacked structure 4210, respectively. For example, the second bonding pads 4250 may be electrically connected to the memory channel structures 4220 and word lines (WL in FIG. 1), respectively, through bit lines 4240 electrically connected to the memory channel structures 4220 and gate connection wirings 4235 electrically connected to word lines (WL in FIG. 1). The first bonding pads 4150 of the first structure 4100 and the second bonding pads 4250 of the second structure 4200 may be coupled to each other while being in contact with each other. The coupled portions of the first bonding pads 4150 and the second bonding pads 4250 may include, for example, copper (Cu).

Each of the semiconductor chips 2200 may further include an input/output pad 2210 and an input/output connection wiring (not shown) below the input/output pad 2210. The input/output connection wiring may be electrically connected to some of the second bonding pads 4250 and some of the peripheral circuit wirings 4110.

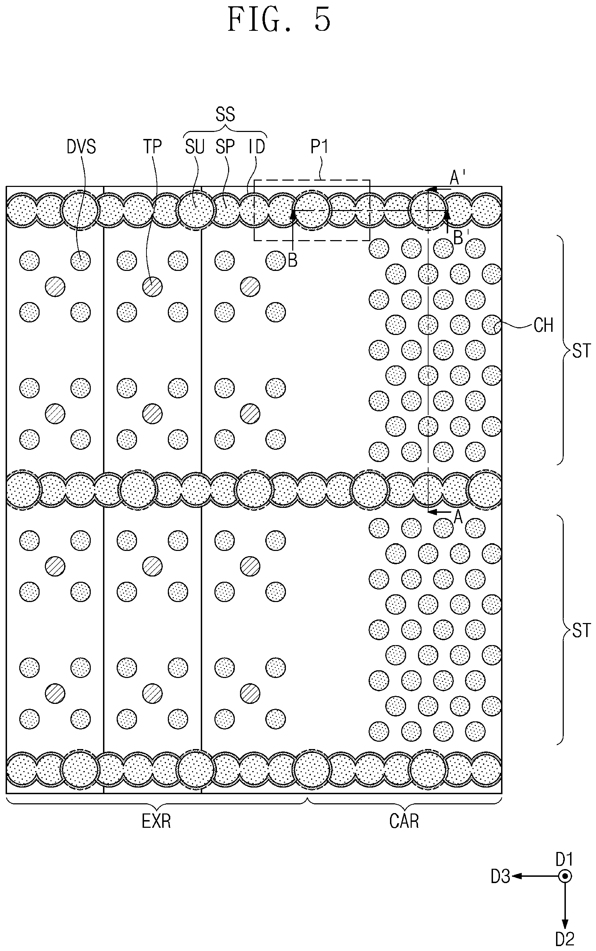

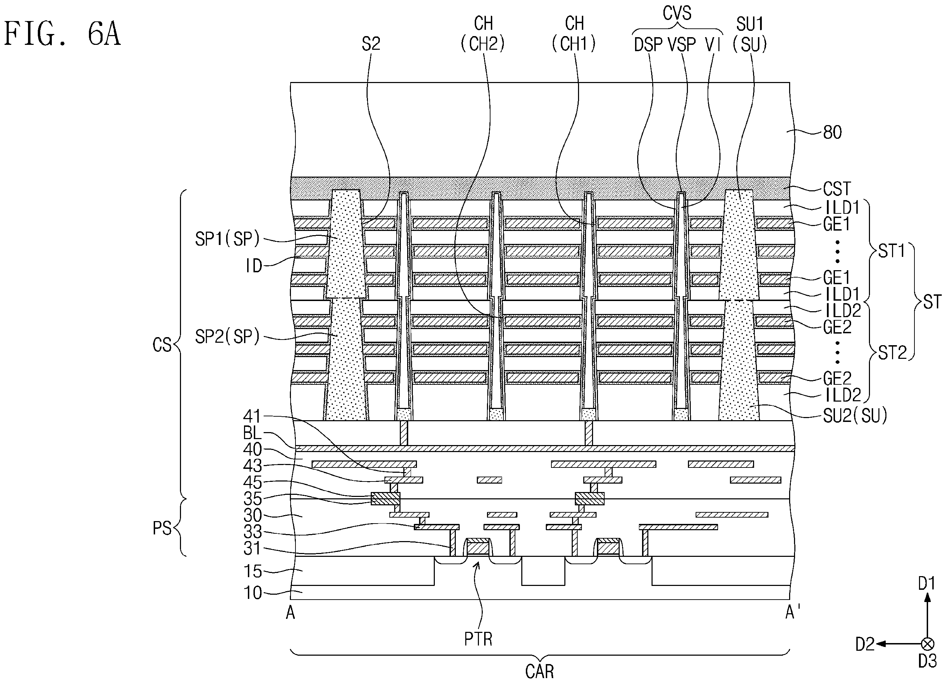

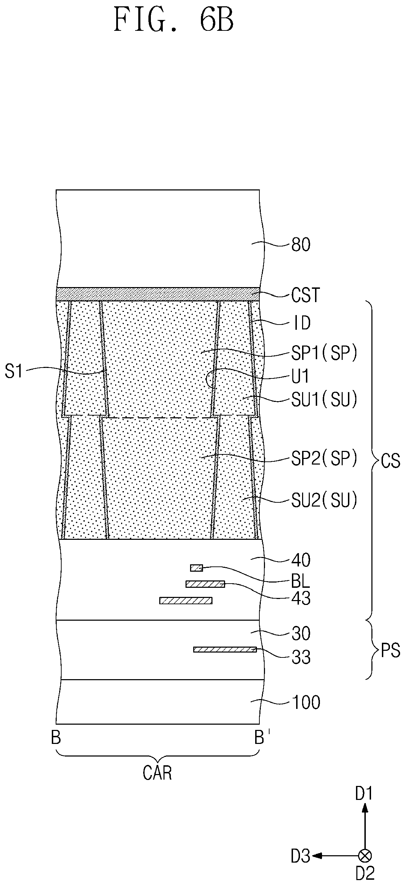

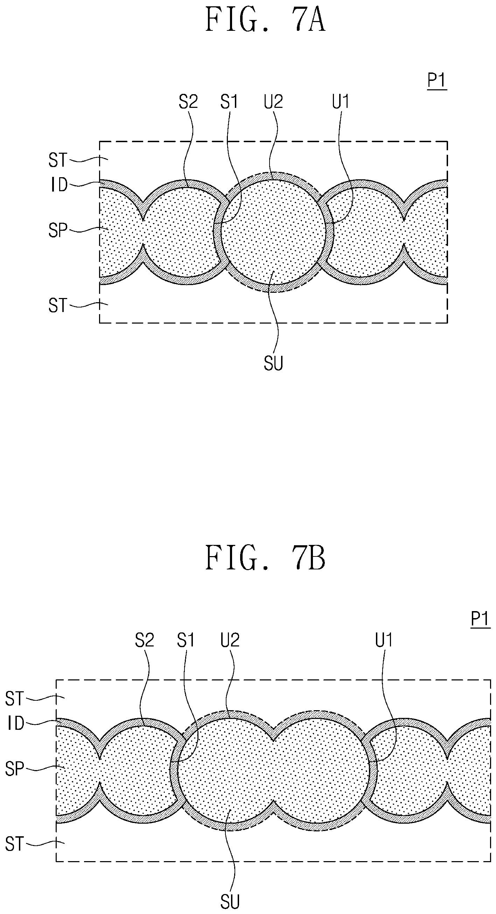

FIG. 5 is a plan view illustrating an example of a three-dimensional semiconductor memory device according to some implementations. FIGS. 6A and 6B are cross-sectional views corresponding to lines A-A' and B-B' of FIG. 5, respectively, according to some implementations. FIGS. 7A and 7B are enlarged views corresponding to an example of a portion 'P1' in FIG. 6A, respectively, according to some implementations.

In FIGS. 5 to 7B, a three-dimensional semiconductor memory device may include a peripheral circuit structure PS and a cell array structure CS stacked on a substrate 10. The substrate 10 may correspond to the semiconductor substrate 3010 (in FIG. 3) or the semiconductor substrate 4010 (in FIG. 4). The peripheral circuit structure PS may correspond to the first structure 3100 (in FIG. 3) or the first structure 4100 (in FIG. 4). The cell array structure CS may correspond to the second structure 3200 (in FIG. 3) or the second structure 4200 (in FIG. 4).

For example, the cell array structure CS may be combined on the peripheral circuit structure PS, thereby increasing a cell capacity per unit area of the three-dimensional semiconductor memory device according to the inventive concept. The peripheral circuit structure PS and the cell array structure CS may be manufactured separately and may be combined with each other through separate processes. Accordingly, peripheral transistors PTR, which will be described later, may be prevented from being damaged by various heat treatment processes. As a result, electrical characteristics and reliability of the three-dimensional semiconductor memory device according to some implementations may be improved. As another example, the cell array structure CS may be manufactured on the peripheral circuit structure PS, and may be electrically connected to the peripheral circuit structure PS through an additional contact (e.g., through wiring 3245 in FIG. 3). Accordingly, unlike FIGS. 6A and 6B, the top and bottom of the cell array structure CS may not be inverted.

The substrate 10 may be, for example, a silicon substrate, a silicon-germanium substrate, a germanium substrate, or a single crystalline epitaxial layer grown on a monocrystalline silicon substrate. An upper surface of the substrate 10 may be perpendicular to a first direction D1. The substrate 10 may have an upper surface parallel to each of second and third directions D2 and D3 that intersect each other. For example, the first to third directions D1, D2, and D3 may be orthogonal to each other. A device isolation layer 15 may be provided in the substrate 10. The device isolation layer 15 may define an active region of the substrate 10.

The peripheral circuit structure PS may include peripheral transistors PTR on the substrate 10, peripheral contact plugs 31, peripheral circuit wirings 33 electrically connected to the peripheral transistors PTR through the peripheral circuit wirings 33, and a first insulating layer 30 surrounding them. The peripheral transistors PTR may be provided on the active region of the substrate 10. The peripheral circuit wirings 33 may correspond to the peripheral circuit wirings 3110 of FIG. 3 or the peripheral circuit wirings 4110 of FIG. 4. First bonding pads 35 may correspond to the first bonding pads 4150 of FIG. 4. As an example, the first bonding pads 35 may be electrically connected to a cell array structure CS, which will be described later, through an additional contact (e.g., through wiring 3245 in FIG. 3).

The peripheral transistors PTR may constitute, for example, a decoder circuit 1110 (in FIG. 1), a page buffer 1120 (in FIG. 1), and a logic circuit 1130 (in FIG. 1). The peripheral circuit wirings 33and the first bonding pads 35 may be electrically connected to the peripheral transistors PTR through the peripheral contact plugs 31. Each of the peripheral transistors

PTR may be, for example, an NMOS transistor or a PMOS transistor.

For example, a width of the peripheral contact plugs 31 toward the first direction D1 may increase in the second direction D2 or the third direction D3. The peripheral contact plugs 31 and peripheral circuit wirings 33 may include a conductive material such as metal.

The first insulating layer 30 may include a plurality of insulating layers having a multilayer structure. As an example, the first insulating layer 30 may include at least one of silicon oxide, silicon nitride, silicon oxynitride, and a low dielectric material. The first insulating layer 30 may not cover upper surfaces of the first bonding pads 35. An upper surface of the first insulating layer 30 may be substantially coplanar with the upper surfaces of the first bonding pads 35.

A cell array structure CS may be provided on the peripheral circuit structure PS. The cell array structure CS may include second bonding pads 45, bit lines BL, and a stacked structure ST. The bit lines BL may correspond to the bit lines 3240 (in FIG. 3) or the bit lines 4240 (in FIG. 4). The stacked structure ST may correspond to the gate stacked structure 3210 (in FIG. 3) or the gate stacked structure 4210 (in FIG. 4). The second bonding pads 45 may correspond to the second bonding pads 4250 (in FIG. 4). As an example, the second bonding pads 45 may be electrically connected to the peripheral circuit structure PS through the additional contact described above. Accordingly, unlike FIGS. 6A and 6B, the top and bottom of the cell array structure CS may not be inverted.

The cell array structure CS may include a cell array region CAR and a cell array extension region EXR. The cell array extension region EXR may extend from the cell array region CAR in the second direction D2, the third direction D3, or the opposite direction thereof.

The second bonding pads 45 may be in contact with the first bonding pads 35 of the peripheral circuit structure PS. The cell circuit wirings 43 may be electrically connected to the second bonding pads 45 through cell contact plugs 41. A second insulating layer 40 may surround the cell contact plugs 41, cell circuit wirings 43, and the second bonding pads 45. The second insulating layer 40, cell contact plugs 41, cell circuit wirings 43, and second bonding pads 45 may be provided on the first insulating layer 30.

The second insulating layer 40 may include a plurality of insulating layers having a multilayer structure. For example, the second insulating layer 40 may include at least one of silicon oxide, silicon nitride, silicon oxynitride, and a low dielectric material.

For example, a width of the cell contact plugs 41 toward the first direction D1 may decrease in the second direction D2 or D3. The cell contact plugs 41 and cell circuit wirings 43 may include a conductive material such as metal.

The bit lines BL may be connected to cell vertical structures CVS, which will be described later, through the cell contact plugs 41. For example, each of the bit lines BL may extend in the second direction D2 and may be spaced apart from each other in the third direction D3. The bit lines BL may include a conductive material such as metal.

The second insulating layer 40 may not cover lower surfaces of the second bonding pads 45. A lower surface of the second insulating layer 40 may be substantially coplanar with the lower surfaces of the second bonding pads 45. The lower surface of each of the second bonding pads 45 may be in direct contact with the upper surface of each of the first bonding pads 35. The first and second bonding pads 35 and 45 may include metal such as copper (Cu), tungsten (W), aluminum (Al), nickel (Ni), or tin (Sn). As an example, the first and second bonding pads 35 and 45 may include copper (Cu). The first and second bonding pads 35 and 45 may form an integrated shape without an interface therebetween. Side walls of the first and second bonding pads 35 and 45 are shown to be aligned side by side, but are not limited thereto, and when viewed in a plan view, the side walls of the first and second bonding pads 35 and 45 may be spaced apart from each other.

The stacked structure ST and a third insulating layer (not shown) may be provided on the second insulating layer 40. The third insulating layer may surround the stacked structure ST. The third insulating layer may include a plurality of insulating layers having a multilayer structure. The third insulating layer may include at least one of silicon oxide, silicon nitride, silicon oxynitride, and a low dielectric material. For example, the third insulating layer may include high density plasma oxide (HDP oxide) or tetraethylorthosilicate (TEOS).

The stacked structure ST may be provided in the plural. For example, when viewed in a plan view, the plurality of stacked structures ST may be spaced apart from each other in the second direction D2 and may each extend in the third direction D3. The stacked structures ST may be spaced apart from each other in the second direction D2 by a separation trench STR which will be described later. Hereinafter, for convenience of explanation, a single stacked structure ST will be described, but the following description may be equally applied to other stacked structures ST.

The stacked structure ST may include a first stacked structure ST1 and a second stacked structure ST2. The first stacked structure ST1 may include first interlayer insulating layers ILD1 and first gate electrodes GE1 that are alternately stacked, and the second stacked structure ST2 may insulating layers ILD2 and second gate electrodes GE2 that are alternately stacked.

The first stacked structure ST1 may be provided on the peripheral circuit structure PS, and the second stacked structure ST2 may be provided between the first stacked structure ST1 and the peripheral circuit structure PS. For example, the second stacked structure ST2 may be provided on a lower surface of the lowermost first interlayer insulating layer ILD1 among the first interlayer insulating layers ILD1 of the first stacked structure ST1. The uppermost second interlayer insulating layer ILD2 of the second stacked structure ST2 and the lowermost first interlayer insulating layer ILD1 of the first stacked structure ST1 may be in contact with each other, but it is not limited thereto. For example, a single-layer interlayer insulating layer may be provided between the uppermost layer of the second gate electrodes GE2 of the second stacked structure ST2 and the first gate electrodes GE1 of the first stacked structure ST1.

As an example, the first and second gate electrodes GE1 and GE2 may include at least one of a doped semiconductor (e.g., doped silicon, etc.), a metal (e.g., tungsten, copper, aluminum, etc.), a conductive metal nitride (e.g., titanium nitride, tantalum nitride, etc.) and a transition metal (e.g., titanium, tantalum, etc.). As an example, the first and second interlayer insulating layers ILD1 and ILD2 may include at least one of silicon oxide, silicon nitride, silicon oxynitride, and a low dielectric material.

As an example, although not shown, a third stacked structure may be further provided between the second stacked structure ST2 and the peripheral circuit structure PS. Characteristics of the third stacked structure may be the same/similar to those of the first stacked structure ST1 and the second stacked structure ST2.

When viewed in a cross-sectional view, the stacked structure ST may have a stepped structure in the third direction D3 on the cell array extension region EXR. For example, a thickness of the stacked structure ST in the cell array extension region EXR in the first direction D1 may decrease as a distance from the cell array region CAR increases. For example, a length of the first and second gate electrodes GE1 and GE2 in the third direction D3 may increase as a distance from the substrate 10 increases. Each of the first and second gate electrodes GE1 and GE2 may include a pad portion (not shown) at one end in the third direction D3. The pad portion may be an region of each of the first and second gate electrodes GE1 and GE2 constituting the stepped structure of the stacked structure ST.

A through plug TP may penetrate the third insulating layer and extend in the first direction D1. The through plug TP may be electrically connected to the pad portion and, for example, may be electrically connected to the corresponding gate electrodes GE1 and GE2 through the pad portion. The through plug TP may include a conductive material such as metal.

One or more of the first gate electrodes GE1 may be ground selection lines GSL. The ground selection line GSL may control the ground selection transistor among the first transistors LT1 and LT2 described with reference to FIG. 1. As an example, the ground selection line GSL may be disposed on an upper portion of the stacked structure ST.

Channel holes CH may penetrate the cell array structure CS in the cell array region CAR and the cell array extension region EXR. Each of the channel holes CH may penetrate at least one of the stacked structure ST and the third insulating layer in the first direction D1. As an example, each of the channel holes CH may include a first channel hole CH1 penetrating the first stacked structure ST1 and a second channel hole CH2 penetrating the second stacked structure ST2. For example, a width of each of the first and second channel holes CH1 and CH2 in the second direction D2 and/or the third direction D3 may decrease as a distance from the substrate 10 increases. The first and second channel holes CH1 and CH2 may be connected to each other. At a boundary where the first and second channel holes CH1 and CH2 are connected, a diameter of the second channel hole CH2 may be smaller than a diameter of the first channel hole CH1. The first and second channel holes CH1 and CH2 may have a step at the boundary where the first and second channel holes CH1 and CH2 are connected to each other. However, the first and second channel holes CH1 and CH2 are not limited thereto, and as an example, unlike shown, three or more channel holes each having a step may be provided at two or more boundaries. As another example, unlike shown, channel holes may be provided that do not have steps and have flat sidewalls.

In the cell array region CAR, the cell vertical structures CVS may penetrate the stacked structure ST in the first direction D1 and fill the channel hole CH. The cell vertical structures CVS may correspond to the memory channel structures 3220 (in FIG. 3) or the memory channel structures 4220 (in FIG. 4).

As an example, a channel pad CHP may be provided at a lower portion of the cell vertical structure CVS. The cell vertical structures CVS may be electrically connected to the cell contact plug 41 and the bit lines BL through the channel pads CHP. In the cell array extension region EXR, dummy vertical structures DVS may penetrate at least one of the stacked structure ST and the third insulating layer in the first direction D1 and fill the channel holes CH, respectively. Each of lower surfaces of the cell vertical structure CVS and the dummy vertical structure DVS may have a circular, oval, or bar shape, for example.

Each of the cell vertical structures CVS includes a data storage pattern DSP that conformally covers an inner sidewall of the channel hole CH, a vertical semiconductor pattern VSP that conformally covers a sidewall of the data storage pattern DSP, and a buried insulating pattern VI surrounded by the vertical semiconductor pattern VSP and the channel pad CHP and filling an inner space of the channel hole CH. The vertical semiconductor pattern VSP may be provided between the data storage pattern DSP and the buried insulating pattern VI. As an example, the vertical semiconductor pattern VSP may include a semiconductor material doped with an impurity, an intrinsic semiconductor material that is not doped with an impurity, or a polycrystalline semiconductor material. As an example, the channel pad CHP may include a semiconductor material or a conductive material doped with impurities.

The data storage pattern DSP may include a blocking insulating layer (not shown), a charge storage layer (not shown), and a tunneling insulating layer (not shown) sequentially stacked on the inner sidewall of the channel hole CH. The charge storage layer may be interposed between the blocking insulating layer and the tunneling insulating layer. The blocking insulating layer, the charge storage layer, and the tunneling insulating layer may extend along the inner wall of the channel hole CH between the stacked structure ST and the vertical semiconductor pattern VSP.

The data storage pattern DSP may store and change data by the Fowler-Nordheim tunneling phenomenon induced due to a voltage difference between the vertical semiconductor pattern VSP and the first and second gate electrodes GE1 and GE2. For example, the blocking insulating layer and the tunneling insulating layer may include silicon oxide, and the charge storage layer may include at least one of silicon nitride and silicon oxynitride.

A source structure CST may be provided on the cell array structure CS and may be in contact with the stacked structure ST, but is not limited thereto. As an example, the source structure CST may be in contact with the stacked structure ST in the cell array structure CS. The source structure CST may extend in the second direction D2 and the third direction D3. The source structure CST may correspond to the common source line 3205 (in FIG. 3) or the common source line 4205 (in FIG. 4).

The source structure CST may include a plurality of source layers having a multi-layer structure. Some of the plurality of source layers may be in contact with cell vertical structures CVS. As an example, the source layers may include at least one of a first conductivity type, for example, an n-type impurity doped semiconductor material (e.g., doped silicon, etc.), a metal material (e.g., Ti, Mo, W, Cu, Al, Ta)., Ru, Ir, Co, Pt, Au, Ag, etc.), a metal nitride (e.g., Ti, Mo, W, Cu, Al, Ta, Ru, Ir, Co, Pt, Au, Ag, etc.), titanium silicon nitride (e.g. TiSiN), titanium aluminum nitride (e.g. TiAlN), tantalum aluminum nitride (e.g. TaAlN), etc.) and conductive oxide (e.g. PtO, RuO2, IrO₂, SrRuO₃ (SRO), (Ba,Sr)RuO₃ (BSRO), CaRuO₃ (CRO), and LSCo). As an example, metal silicide may be further provided between source layers.

A separation structure SS may be interposed between adjacent stacked structures ST in the second direction D2. The separation structure SS may extend in the third direction D3 and may be spaced apart from the stacked structures ST in the second direction D2. The separation structure SS may extend from the cell array region CAR toward the cell array extension region EXR. The separation structure SS may be provided in the plural. The separation structures SS may be adjacent to each other in the second direction D2.

The separation structure SS may include support patterns SU and separation patterns SP alternately arranged in the third direction D3, and an internal insulating layer ID surrounding them. Hereinafter, the support patterns SU, separation patterns SP, and internal insulating layer ID will be described in detail.

The support patterns SU may extend in the first direction D1 and the third direction D3 between the stacked structures ST. The support patterns SU may be arranged to be spaced apart from each other in the third direction D3 in the separation structure SS. The support patterns SU may be arranged adjacent to each other in the second direction D2. The support patterns SU may be in contact with the first and second interlayer insulating layers ILD1 and ILD2, but may be spaced apart from the first and second gate electrodes GE1 and GE2. As an example, the support pattern SU may include an insulating material.

The support pattern SU may include a first support pattern SU1 between the first stacked structures ST1 and a second support pattern SU2 between the second stacked structures ST2. For example, a width of each of the first and second support patterns SU1 and SU2 in the second direction D2 and the third direction D3 may decrease as a distance from the substrate 10 increases. The first and second support patterns SU1 and SU2 may be in contact with each other and may not be distinguished from each other. At a level where the first and second structures ST1 and ST2 are in contact with each other, a diameter of the first support pattern SU1 may be larger than a diameter of the second support pattern SU2. The first and second support patterns SU1 and SU2 may have a step at a level where the first and second structures ST1 and ST2 are in contact with each other. However, the first and second support patterns SU1 and SU2 are not limited thereto, and as an example, unlike shown, three or more support patterns each having a step may be provided at two or more boundaries. As another example, unlike shown, support patterns may be provided that do not have steps and have flat sidewalls.

The separation patterns SP may extend in the first direction D1 and the third direction D3 between the stacked structures ST. The separation patterns SP may be arranged adjacent to each other in the second and third directions D2 and D3. The separation patterns SP may be in contact with the first and second gate electrodes GE1 and GE2, but may not be in contact with the first and second interlayer insulating layers ILD1 and ILD2. As an example, the separation pattern SP may include an insulating material.

The separation pattern SP may include a first separation pattern SP1 between the first stacked structures ST1 and a second separation pattern SP2 between the second stacked structures ST2. As an example, a width of each of the first and second support patterns SU1 and SU2 in the second direction D2 may decrease as a distance from the substrate 10 increases (refer to FIG. 6A), and a width in the third direction D3 may increase (refer to FIG. 6b). The first and second separation patterns SP1 and SP2 may be in contact with each other and may not be distinguished from each other. The first and second separation patterns SP1 and SP2 may have a step at a level where the first and second separation patterns SP1 and SP2 are in contact with each other, but are not limited thereto.

The support pattern SU may include a first side surface U1 covering the separation pattern SP (refer to FIG. 7A). The separation pattern SP may include a first side surface S1 covering the first side surface U1 of the support pattern SU. Each of the support pattern SU and the separation pattern SP may include second side surfaces U2 and S2 covering the sidewalls of the stacked structure ST. When viewed in a plan view, the first side surface S1 of the separation pattern SP may be concave toward the inside of the separation pattern SP. When viewed in a plan view, the second side surface S2 of the separation pattern SP may have a wavy profile.

For example, as shown in FIG. 7A, when viewed in a plan view, the support pattern SU may have a circular shape, but is not limited thereto. As an example, the support pattern SU may have at least one shape among a circle, an oval, and a rectangle with rounded four corners.

As another example, as shown in FIG. 7B, when viewed in a plan view, the support pattern SU may have a shape in which a plurality of sub-support patterns overlap. One sub-support pattern may have a shape similar to the support pattern SU in FIG. 7A when viewed in a plan view. Specifically, the sub-support patterns may each have at least one shape among a circle, an oval, and a rectangle with rounded four corners, and one support pattern SU may have a shape in which the sub-support patterns partially overlap each other. As an example, the sub-support patterns may be arranged in the third direction D3. In FIG. 7B, two sub-support patterns are shown overlapping each other to form one support pattern SU, but the inventive concept is not limited thereto. Three or more sub-support patterns may overlap and form one support pattern SU.

The internal insulating layer ID may surround side surfaces of the support patterns SU. Specifically, the internal insulating layer ID may cover a portion of the second side surface U2 of the support pattern SU on the side surfaces of the first and second gate electrodes GE1 and GE2. Accordingly, the support pattern SU may be spaced apart from the first and second gate electrodes GE1 and GE2. The internal insulating layer ID may not cover another portion of the second side surface U2 of the support pattern SU on side surfaces of the first and second interlayer insulating layers ILD1 and ILD2.

The internal insulating layer ID may not cover a portion of the second side surface S2 of the separation pattern SP on side surfaces of the first and second gate electrodes GE1 and GE2. The internal insulating layer ID may cover another portion of the second side surface S2 of the separation pattern SP on the side surfaces of the first and second interlayer insulating layers ILD1 and ILD2.

The internal insulating layer ID may cover a portion of the side surface of the cell vertical structure CVS on the side surfaces of the first and second gate electrodes GE1 and GE2. The internal insulating layer ID may cover upper surfaces of the first and second gate electrodes GE1 and GE2 and lower surfaces of the first and second interlayer insulating layers ILD1 and ILD2. The internal insulating layer ID may cover upper surfaces of the first and second interlayer insulating layers ILD1 and ILD2 on lower surfaces of the first and second gate electrodes GE1 and GE2.

The internal insulating layer ID may be interposed between the first side surface U1 of the support pattern SU and the first side surface S1 of the separation pattern SP. Accordingly, the support pattern SU and the separation pattern SP may be spaced apart from each other in the third direction D3.

A protective layer 80 may be provided on a front surface of the cell array structure CS. The protective layer 80 may be a single layer formed of a single material or a composite layer containing two or more materials. As an example, the protective layer 80 may have a structure in which polyimide-based materials such as silicon oxide, silicon nitride, and photo sensitive polyimide (PSPI) are sequentially stacked, but is not limited thereto. The protective layer 80 may have an opening that exposes a portion of the input/output pads, and upper wirings may be provided in the protective layer 80 and may be electrically connected to the cell array structure CS.

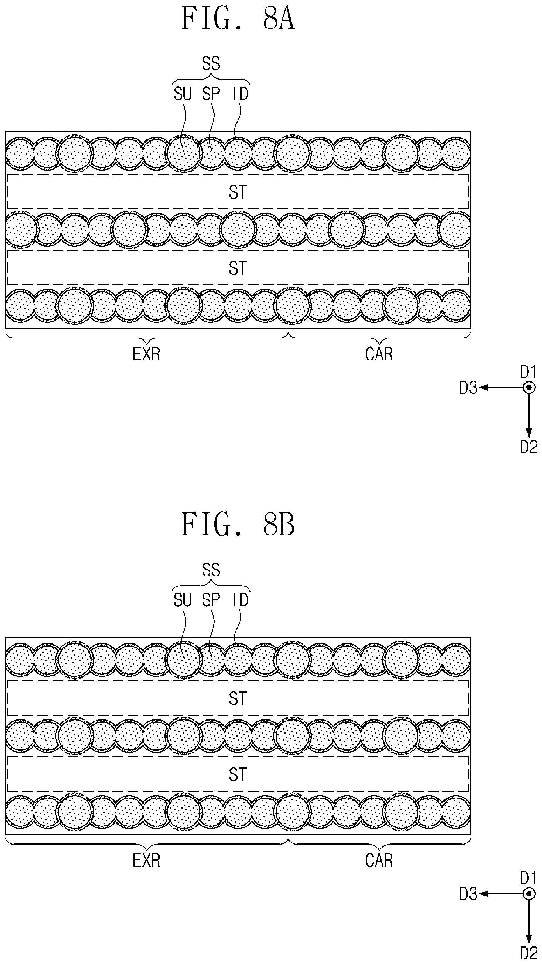

Hereinafter, various implementations of a three-dimensional semiconductor memory device will be described with reference to FIGS. 8A to 8C. For simplicity of explanation, descriptions that overlap with the above are omitted.

FIGS. 8A to 8C are plan views schematically illustrating examples of three-dimensional semiconductor memory devices according to some implementations. In FIGS. 8A to 8C, arrangement of the support patterns SU and the separation patterns SP may be variously changed according to some implementations. Specifically, the support patterns SU arranged in the second direction D2 may be arranged in a zigzag shape or a straight line. For example, as shown in FIG. 8A, the support patterns SU may be arranged in a zigzag shape in the second direction D2, and the separation patterns SP may also be arranged in a zigzag shape in the second direction D2. For example, two support patterns SU may be arranged adjacent to each other in the second direction D2, and one of the support pattern SU may be offset from the other thereof in the third direction D3.

As another example, as shown in FIG. 8B, the support patterns SU may be arranged in a line in the second direction D2, and the separation patterns SP may also be arranged in a line in the second direction D2.

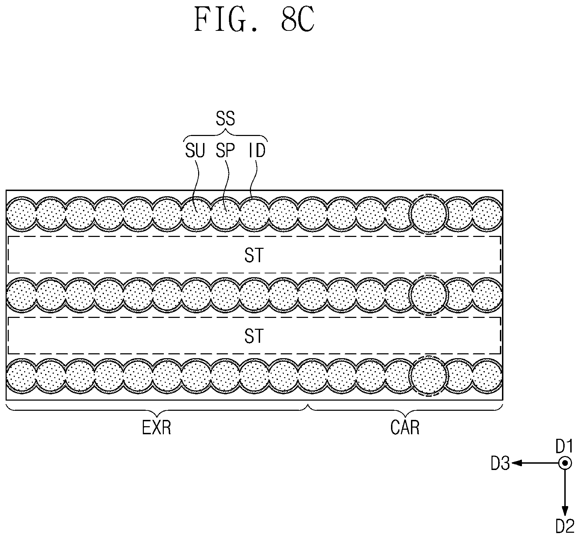

As another example, as shown in FIG. 8C, the support patterns SU may be arranged in the cell array region CAR, but may not be arranged in the cell array extension region EXR. The arrangement of the support patterns SU and the separation patterns SP is not limited to the arrangements of FIGS. 8A to 8C.

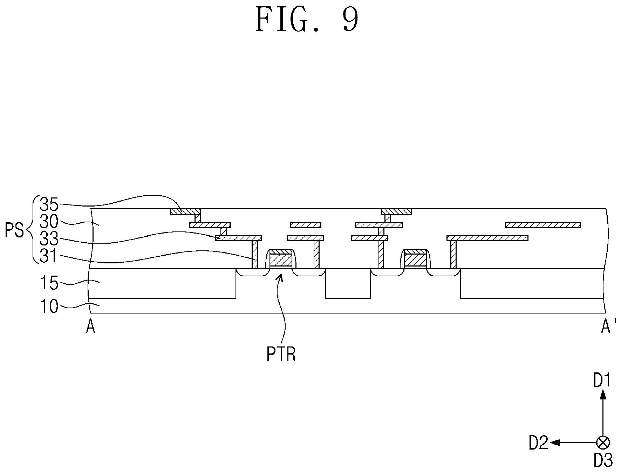

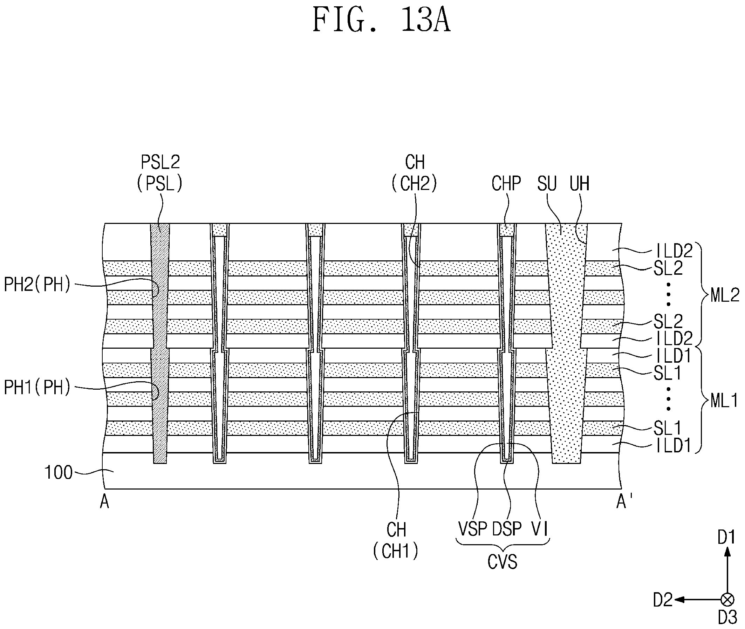

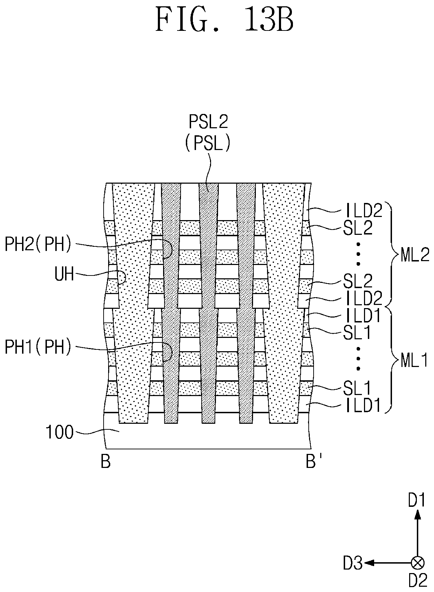

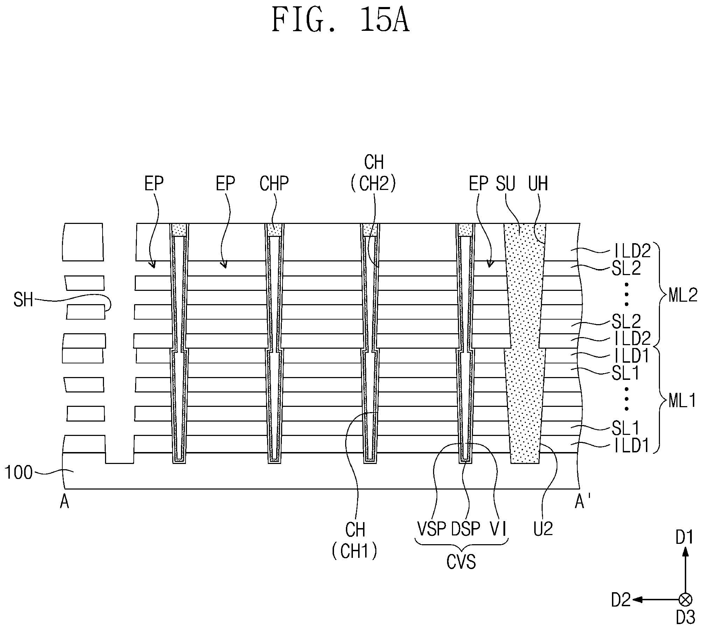

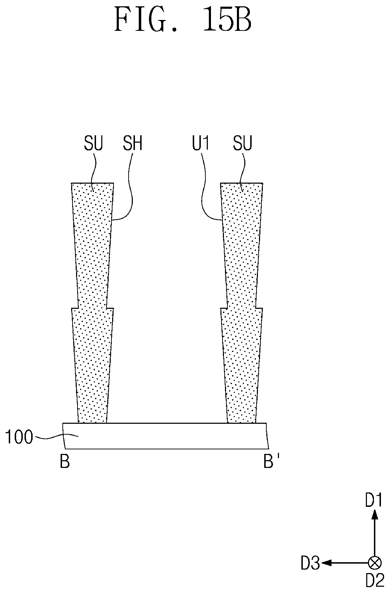

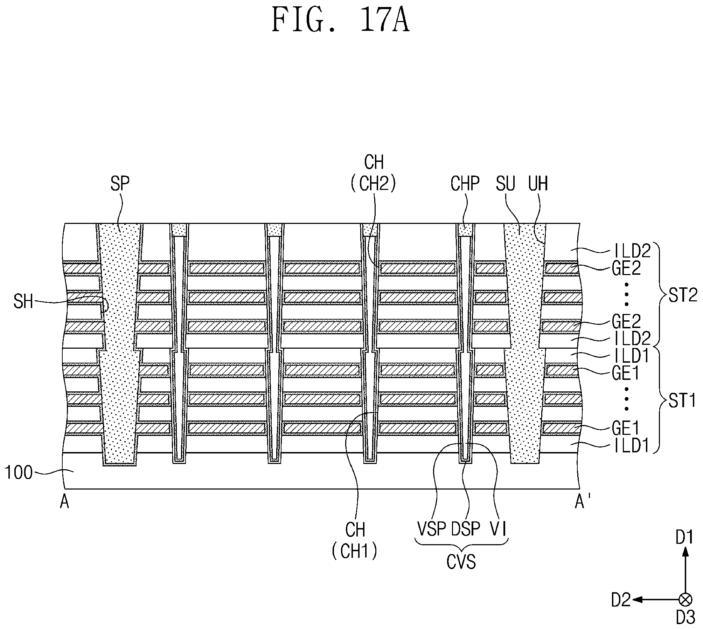

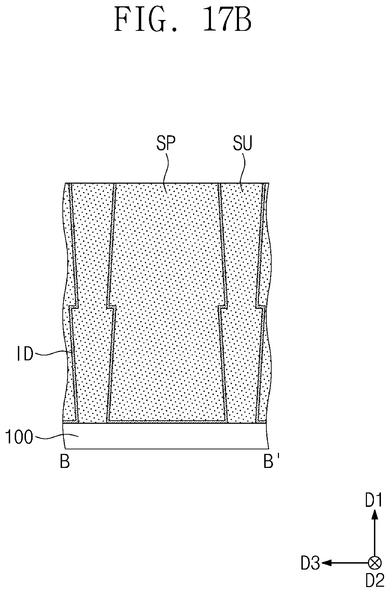

FIGS. 9 to 17B are cross-sectional views illustrating an example of a method of manufacturing a three-dimensional semiconductor memory device according to some implementations. For purposes of simplified explanation, description of the disclosure that overlaps with the above-described disclosure will be omitted, and the following explanations will focus on the differences from the above-described content.

In FIGS. 5 and 9, a peripheral circuit structure PS may be formed on aa substrate 10. Forming the peripheral circuit structure PS may include forming a device isolation layer 15 in the substrate 10, forming peripheral transistors PTR on an active region of the substrate 10 defined by the device isolation layer 15 and forming peripheral contact plugs 31 electrically connected to peripheral transistors PTR, peripheral circuit wirings 33, first bonding pads 35, and a first insulating layer 30 covering them.

Upper surfaces of the first bonding pads 35 may be substantially coplanar with an upper surface of the first insulating layer 30. Hereinafter, such "substantially coplanar" structure can result from a planarization process. The planarization process may be performed, for example, through a chemical mechanical polishing (CMP) process or an etch back process.

The "upper surface" may refer to the "lower surface" when viewed in a perspective view of the three-dimensional semiconductor memory manufactured as described with reference to FIGS. 6A and 6B, and the "lower surface" may refer to the "upper surface" when viewed in a perspective view of the three-dimensional semiconductor memory completely manufactured as described with reference to FIGS. 6A and 6B. Likewise, the "upper" and the "lower" may refer to "lower" and "upper" when viewed in a perspective view of the three-dimensional semiconductor memory completely manufactured as described with reference to FIGS. 6A and 6B.

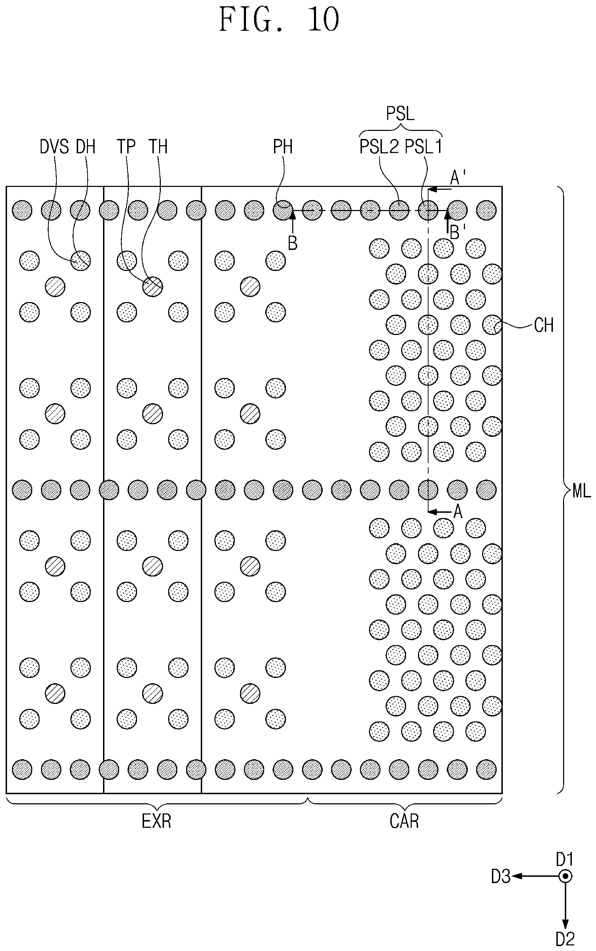

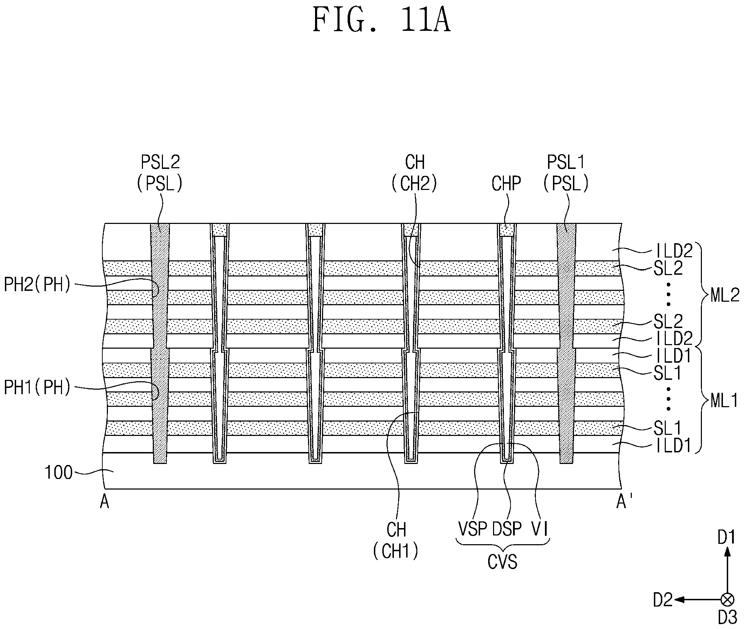

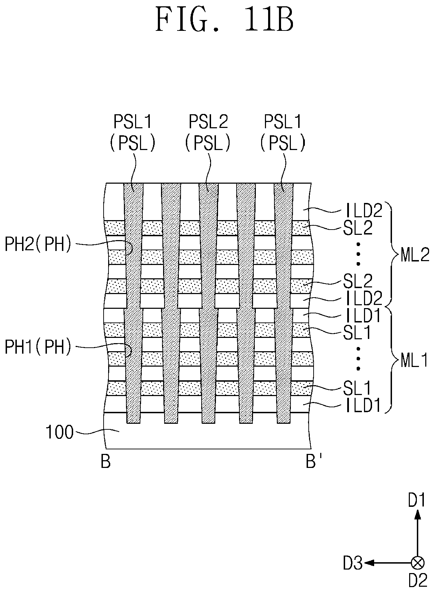

In FIGS. 10 to 11B, a cell array substrate 100 may be provided. As an example, the cell array "upper surface", "lower surface", "upper portion", and "lower portion" substrate 100 may be a silicon substrate, a silicon-germanium substrate, a germanium substrate, or a single crystal epitaxial layer grown on a monocrystalline silicon substrate. As an example, the cell array substrate 100 may further include at least one of silicon oxide and polysilicon.

A mold structure ML may be formed on the cell array substrate 100. The mold structure ML may include a first mold structure ML1 and a second mold structure ML2 on the first mold structure ML1. Forming the mold structure ML may include sequentially forming the first mold structure ML1 and the second mold structure ML2.

For example, the first mold structure ML1 may be formed on the cell array substrate 100. Forming the first mold structure ML1 may include alternately stacking first interlayer insulating layers ILD1 and first sacrificial layers SL1. In the first mold structure ML1, the first sacrificial layers SL1 may be formed of a material that may be etched with etch selectivity with respect to the first interlayer insulating layers ILD1. For example, the first sacrificial layers SL1 may be formed of an insulating material different from that of the first interlayer insulating layers ILD1. For example, the first sacrificial layers SL1 may include silicon nitride, and the first interlayer insulating layers ILD1 may include silicon oxide.

Thereafter, a first channel hole CH1, a first preliminary hole PH1, a first through hole (not shown), and a first dummy channel hole (not shown) may be formed to penetrate the first interlayer insulating layers ILD1 and the first sacrificial layers SL1 in the first direction D1, respectively.

A second mold structure ML2 may be formed on the first mold structure ML1. The second mold structure may include second interlayer insulating layers ILD2 and second sacrificial layers SL2 that are alternately stacked. Characteristics of the second interlayer insulating layers ILD2 and the second sacrificial layers SL2 may be the same/similar to those of the first interlayer insulating layers ILD1 and the first sacrificial layers SL1.

Thereafter, a second channel hole CH2, a second preliminary hole PH2, a second through hole (not shown), and a second dummy channel hole (not shown) may be formed to penetrate the second interlayer insulating layers ILD2 and the second sacrificial layers SL2 in the first direction D1, respectively.

The second channel hole CH2, the second preliminary hole PH2, the second through hole, and the second dummy channel hole may vertically overlap the first channel hole CH1, the first preliminary hole PH1, the first through hole, and the first dummy channel hole, respectively. The first channel hole CH1 and the second channel hole CH2 may constitute a channel hole CH. The first preliminary hole PH1 and the second preliminary hole PH2 may constitute a preliminary hole PH. The preliminary holes PH may be formed to be arranged in a row in the mold structure ML. The first through hole and the second through hole may constitute a through hole TH. The first dummy channel hole and the second dummy channel hole may constitute a dummy channel hole DH.

A cell vertical structure CVS, a dummy vertical structure DVS, and a through plug TP may be formed to fill the channel hole CH, the dummy channel hole DH, and the through hole TH, respectively. Forming the cell vertical structure CVS may include sequentially forming a data storage pattern DSP, a vertical semiconductor pattern VSP, and a buried insulating pattern VI in the channel hole CH. Subsequently, a channel pad CHP may be formed to fill an upper portion of the channel hole CH. The dummy vertical structure DVS may be formed together with the cell vertical structure CVS, or may be formed through a separate process from the cell vertical structure CVS. When forming the cell vertical structure CVS, the preliminary sacrificial patterns PSL may fill the preliminary holes PH such that the cell vertical structure CVS is not formed in the preliminary holes PH.

The preliminary sacrificial pattern PSL may include a first preliminary sacrificial pattern PSL1 and a second preliminary sacrificial pattern PSL2. The first preliminary sacrificial pattern PSL1 may be formed in a region where a support pattern SU is formed during a subsequent process. The second preliminary sacrificial pattern PSL2 may be formed in a region where a separation pattern SP is formed during a subsequent process. The plurality of first preliminary sacrificial patterns PSL1 may be adjacent to each other in the third direction D3. The plurality of second preliminary sacrificial patterns PSL2 may be interposed between a pair of adjacent first preliminary sacrificial patterns PSL1 in the third direction D3. Although three second preliminary sacrificial patterns PSL2 are shown interposed between the first preliminary sacrificial patterns PSL1, the inventive concept is not limited thereto. As an example, two or more second preliminary sacrificial patterns PSL2 may be interposed, and as another example, one second preliminary sacrificial pattern PSL2 may be interposed.

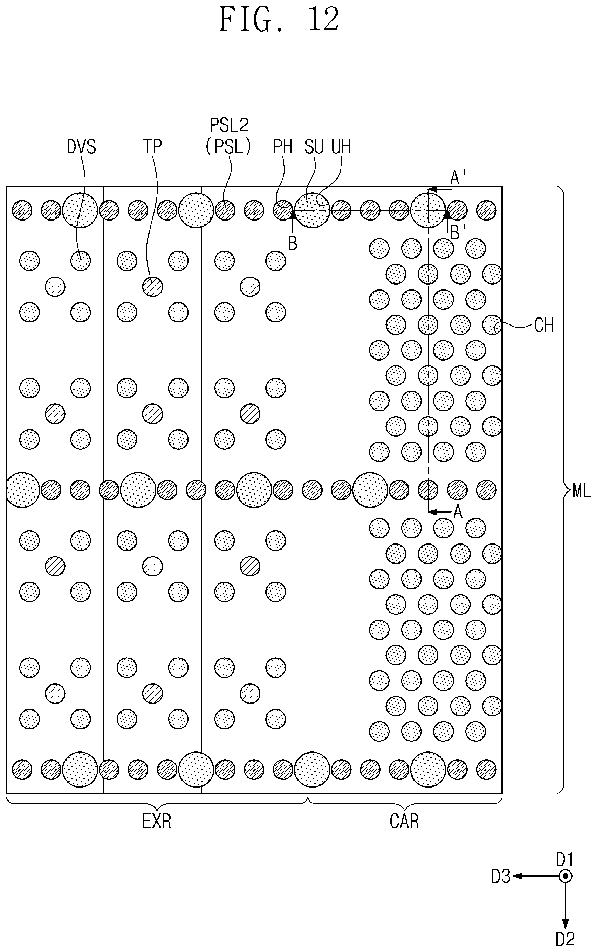

In FIGS. 12 to 13B, support holes UH may be formed in the mold structure ML. Forming the support holes UH may include exposing surfaces of the first preliminary sacrificial patterns PSL1 to the outside and forming a mask pattern (not shown) covering upper surfaces of the second preliminary sacrificial patterns PSL2, removing the first preliminary sacrificial patterns PSL1 exposed to the outside to expose some of the preliminary holes PH to the outside, and performing an enlarge process on exposed preliminary holes PH to the outside. The enlarge process may include performing an isotropic etching process on the exposed preliminary holes PH. Through the etching process, a diameter of the support hole UH may be formed to be larger than a diameter of the preliminary hole PH. Thereafter, support patterns SU may be formed to fill the support holes UH.

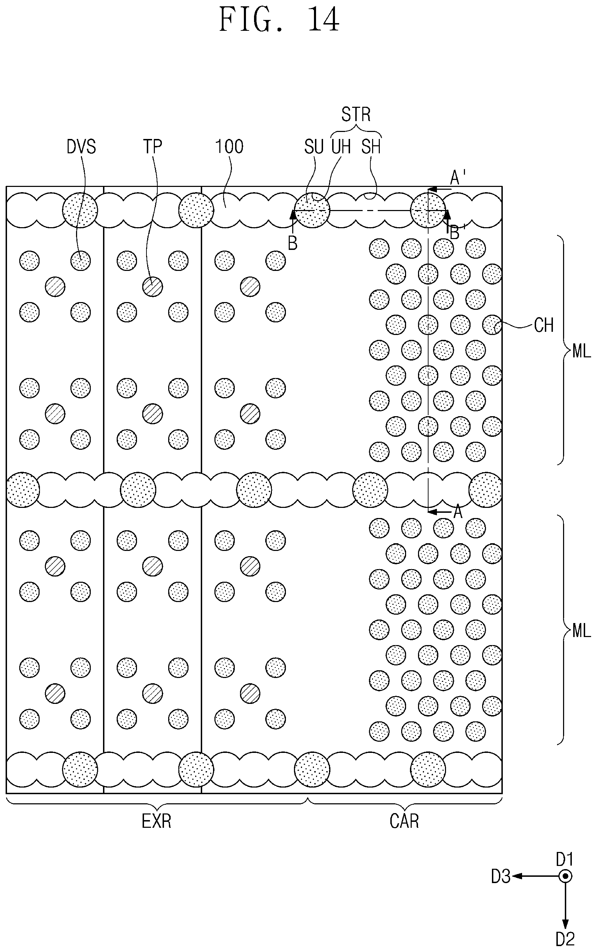

In FIGS. 14 to 15B, separation holes SH may be formed in the mold structure ML. The separation holes SH may be formed adjacent to each other in the third direction D3 with the support pattern SU interposed therebetween. Forming the separation holes SH may include removing the second preliminary sacrificial patterns PSL2 to expose the remaining preliminary holes PH to the outside, and performing an enlarge process on externally exposed preliminary holes PH. As a diameter of each of the preliminary holes PH gradually increases through the enlarge process, adjacent preliminary holes PH may overlap each other to form one separation hole SH. During the process of forming the separation holes SH, a first side surface U1 of each of the support patterns SU may be exposed to the outside.

The separation holes SH and the support holes UH may be formed to be alternately arranged in the third direction D3 and may be continuously connected. The separation holes SH and the support holes UH may be connected to each other to form one separation trench STR. One mold structure ML may be separated into mold structures ML spaced apart from each other in the second direction D2 by the separation trench STR.

Thereafter, an isotropic etching process using the separation trench STR as a path may be performed, and the first sacrificial layers SL1 and the second sacrificial layers SL2 may be removed. Accordingly, removal regions EP may be formed, and a portion of the second side surface S2 of each of the support patterns SU may be exposed to the outside by the removal regions EP.

According to some implementations, the support patterns SU may be formed to fill the support holes UH. The support patterns SU may be in contact with the first and second interlayer insulating layers ILD1 and ILD2 of the mold structures ML and may support the mold structures ML. Even when the first and second sacrificial layers SL1 and SL2 are removed, the mold structures ML may not collapse. Accordingly, productivity of the three-dimensional semiconductor memory device may be improved.

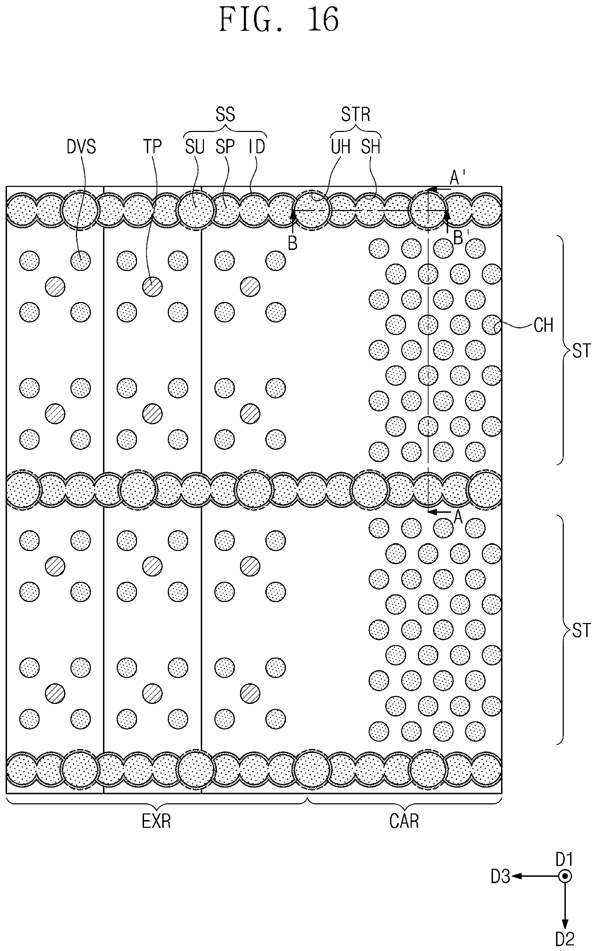

In FIGS. 16 to 17B, an internal insulating layer ID may be formed to conformally cover a portion of the removal region EP, the sidewall of the separation hole SH, and the second side surface US2 of the support pattern SU. The internal insulating layer ID may be formed to cover the first sides U1 and S 1 of each of the support pattern SU and the separation pattern SP.

Then, the first and second gate electrodes GE1 and GE2 may be formed to fill the remainder of the removal regions EP. Accordingly, stacked structures ST may be formed. Thereafter, separation patterns SP may be formed to fill the separation holes SH.

In FIGS. 5 to 6B, the peripheral circuit structure PS and the cell array structure CS may be combined with each other. The first bonding pads 35 of the peripheral circuit structure PS and the second bonding pads 45 of the cell array structure CS may be bonded to each other. Accordingly, the top and bottom of the cell array structure CS may be reversed. Accordingly, when the method of manufacturing the semiconductor device after bonding, "upper surface", "lower surface", "upper portion", and "lower portion" may be referred to as "upper surface", "lower surface", "upper portion", and "lower portion" described with reference to FIGS. 6A to 6C.

After bonding, the cell array substrate 100 may be removed from the cell array region CAR. The removal process may include at least one of a grinding process, a planarization process, a dry etching process, and a wet etching process. During the removal process, the data storage pattern DSP of the cell vertical structure CVS and the uppermost first interlayer insulating layer ILD1 may be exposed to the outside. The exposed portion of the data storage pattern DSP may then be removed. Accordingly, the vertical semiconductor pattern VSP may be exposed in the channel hole CH.

A source structure CST may be formed on the cell array structure CS. Thereafter, a protective layer 80 may be formed on a front surface of the cell array structure CS.

According to some implementations, the support patterns may be formed to fill the support holes. The support patterns may be in contact with the first and second interlayer insulating layers of the mold structures and support the mold structures. Accordingly, even when the first and second sacrificial layers are removed, the mold structures may not collapse. Accordingly, the productivity of the three-dimensional semiconductor memory device may be improved.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A three-dimensional semiconductor memory device comprising:
a plurality of peripheral circuit structures on a substrate;
a plurality of stacked structures, each of the plurality of stacked structures including a plurality of gate electrodes stacked on the plurality of peripheral circuit structures in a first direction perpendicular to a lower surface of the substrate, and the plurality of stacked structures being spaced apart from each other in a second direction parallel to the lower surface of the substrate;
a separation structure extending between the plurality of stacked structures in a third direction intersecting the first direction and the second direction, the separation structure including a plurality of support patterns that are spaced apart from each other in the third direction in the separation structure; and
an internal insulating layer surrounding a side surface of each of the plurality of support patterns.

2. The three-dimensional memory device of claim 1, wherein the internal insulating layer includes metal oxide.

3. The three-dimensional memory device of claim 1, wherein the internal insulating layer is interposed between the plurality of support patterns and the plurality of gate electrodes.

4. The three-dimensional memory device of claim 1, wherein the plurality of support patterns are spaced apart from the plurality of gate electrodes.

5. The three-dimensional memory device of claim 1, wherein an upper surface of each of the plurality of support patterns has at least one shape of a circle, an oval, and a rectangle with four rounded corners.

6. The three-dimensional memory device of claim 1,
wherein the separation structure includes a plurality of separation structures disposed in the second direction,
wherein each of the plurality of separation structures includes the plurality of support patterns, and
wherein the plurality of support patterns are arranged in a zigzag shape or a row in the second direction.

7. The three-dimensional memory device of claim 1, wherein the separation structure further includes a plurality of separation patterns alternately arranged with the plurality of support patterns in the third direction.

8. The three-dimensional memory device of claim 7,
wherein each of the plurality of support patterns has a first side surface covering a side surface of each of the plurality of support patterns corresponding to each of the plurality of support patterns, and
wherein the internal insulating layer covers the first side surface of each of the plurality of support patterns.

9. The three-dimensional memory device of claim 8, wherein the side surface of each of the plurality of separation patterns is curved toward an inside of each of the plurality of separation patterns.

10. The three-dimensional memory device of claim 7, wherein the plurality of support patterns are spaced apart from the plurality of separation patterns.
